# EUROPEAN PATENT APPLICATION

(11) **EP 3 247 185 A1**
(43) Date of publication of application: **22.11.2017**
(21) Application number: 15878380.3
(22) Date of filing: 22.01.2015
(51) Int. Cl.: H05K 7/20, H05K 1/09

(54) **HEAT DISSIPATION APPARATUS FOR SMALL-SIZE DEVICE AND CIRCUIT BOARD HEAT DISSIPATION SYSTEM**

(71) Applicant: Huawei Technologies Co. Ltd., Shenzhen, Guangdong 518129 (CN)
(72) Inventor: CHEN, Dengxu, Shenzhen Guangdong 518129 (CN); LIU, Guangming, Shenzhen Guangdong 518129 (CN); DENG, Yishi, Shenzhen Guangdong 518129 (CN); WANG, Houxin, Shenzhen Guangdong 518129 (CN); ZHOU, Liechun, Shenzhen Guangdong 518129 (CN)
(74) Representative: Körber, Martin Hans
(86) International application number: PCT/CN2015/071292
(87) International publication number: WO 2016/115702

(57) **Abstract**

A heat dissipation apparatus for a small-sized device and a circuit board heat dissipation system are disclosed, where the apparatus includes a small-sized device (102) that is welded to a copper sheet (103) on a circuit board (101) and a heat sink (104) that is welded to another copper sheet (105) on the circuit board and that surrounds the small-sized device. Therefore, production costs of the small-sized device are reduced.

## Description

### TECHNICAL FIELD

The present invention relates to the heat dissipation field, and in particular, to a heat dissipation apparatus for a small-sized device and a circuit board heat dissipation system.

### BACKGROUND

Heat power consumption of some electronic devices in a communications terminal product is low. However, actual temperature rises of the electronic devices are high because sizes of the electronic devices are small. For example, power consumption of a surface-mounted LED is generally around 0.01 W, and a size of the LED is approximately 1 mm x 0.5 mm. A temperature rise caused by heat of the LED may be more than 10 degrees centigrade, and the LED is affected by a nearby heat emitting device. Consequently, a temperature of the LED may easily go beyond a specification. For another example, a transistor device does not emit heat, but the transistor device is temperature-sensitive. A nearby heat source transfers heat to the transistor through a copper sheet on a circuit board, so that a temperature of the transistor easily goes beyond a temperature specification that can be endured by the transistor.

Currently, there are various methods for resolving a heat dissipation problem. However, these methods have their own disadvantages. For example, a printed circuit board (Printed Circuit Board, PCB) may be enlarged enough. However, the method goes against a miniaturization trend of a consumer product and greatly increases costs. For another example, a copper sheet on a board under a small-sized device (for example, a transistor) that does not emit heat may be cut, to isolate the copper sheet under the small-sized device from another copper sheet on the board, and then FR4 with a small thermal conductivity coefficient is filled in the part in which the copper sheet is cut, to increase thermal-conduction resistance from another heat source to the transistor. FR4 is a fire resistance class of a flame retardant material. However, nowadays, a product miniaturization trend becomes increasingly apparent; and as a product becomes smaller and smaller, a temperature of the transistor may still go beyond a specification.

### SUMMARY

Embodiments of the present invention provide a heat dissipation apparatus for a small-sized device and a circuit board heat dissipation system, so as to reduce a temperature rise of a small-sized device and reduce heat dissipation costs of the small-sized device.

A first aspect of the embodiments of the present invention provides a heat dissipation apparatus for a small-sized device, configured to dissipate heat of a small-sized device on a circuit board, where the heat dissipation apparatus includes a heat sink;
the small-sized device is welded to a copper sheet on the circuit board; and
the heat sink is welded to a copper sheet on the circuit board and surrounds the small-sized device.

With reference to the first aspect of the embodiments of the present invention, in a first implementation manner of the first aspect of the embodiments of the present invention, that the heat sink is welded to the copper sheet on the circuit board specifically includes the following:
the heat sink is directly welded to the copper sheet on the circuit board by a chip mounter by using a surface mount SMT technology.

With reference to the first aspect or the first implementation manner of the first aspect of the embodiments of the present invention, in a second implementation manner of the first aspect of the embodiments of the present invention, a material of the heat sink is copper or matte tinplate.

With reference to the first aspect or the first implementation manner of the first aspect of the embodiments of the present invention, in a third implementation manner of the first aspect of the embodiments of the present invention, a material of the heat sink is stainless steel, aluminum, or galvanized steel sheet, and a surface of the heat sink is nickel-plated.

With reference to any one of the first aspect, or the first to the third implementation manners of the first aspect of the embodiments of the present invention, in a fourth implementation manner of the first aspect of the embodiments of the present invention, the heat sink is shaped by stamping and bending a sheet material.

With reference to the fourth implementation manner of the first aspect of the embodiments of the present invention, in a fifth implementation manner of the first aspect of the embodiments of the present invention, the heat sink is Ω-shaped or pyramid-shaped.

With reference to any one of the first aspect, or the first to the fifth implementation manners of the first aspect of the embodiments of the present invention, in a sixth implementation manner of the first aspect of the embodiments of the present invention, the heat sink and the small-sized device are respectively distributed on both sides of the circuit board, and a center of the small-sized device and a central point of the heat sink are located on a same perpendicular line perpendicular to the circuit board.

With reference to any one of the first aspect, or the first to the fifth implementation manners of the first aspect of the embodiments of the present invention, in a seventh implementation manner of the first aspect of the embodiments of the present invention, the heat sink and the small-sized device are respectively distributed on both sides of the circuit board, and a central point of the small-sized device and a central point of the heat sink are not located on a same perpendicular line perpendicular to the circuit board.

With reference to the sixth implementation manner of the first aspect or the seventh implementation manner of the first aspect of the embodiments of the present invention, in an eighth implementation manner of the first aspect of the embodiments of the present invention, a welded copper sheet of the heat sink is connected to a welded copper sheet of the small-sized device by using a through hole in the circuit board.

With reference to any one of the first aspect, or the first to the fifth implementation manners of the first aspect of the embodiments of the present invention, in a ninth implementation manner of the first aspect of the embodiments of the present invention, both the heat sink and the small-sized device are distributed on a same side of the circuit board.

A second aspect of the embodiments of the present invention provides a circuit board heat dissipation system, including:
a circuit board, a small-sized device welded to the circuit board, and the heat dissipation apparatus provided in any one of the first aspect or the first to the ninth implementation manners of the first aspect of the embodiments of the present invention.

With reference to the second aspect of the embodiments of the present invention, in a first implementation manner of the second aspect of the embodiments of the present invention, in addition to the small-sized device, another component is welded to the circuit board; and
a welded copper sheet of the small-sized device is isolated from a welded copper sheet of the another component by using FR4.

It can be learned from the foregoing technical solutions that the embodiments of the present invention have the following advantages: In the embodiments of the present invention, a heat sink is welded near a small-sized device, so that the heat sink can dissipate heat generated by the small-sized device or heat conducted by a nearby component, and a temperature rise of the small-sized device is greatly reduced. In addition, the heat sink is welded to a circuit board, and therefore no other fastening structure is required. The heat sink has a simple structure, thereby meeting a product miniaturization trend and reducing heat dissipation costs of the small-sized device.

### BRIEF DESCRIPTION OF DRAWINGS

FIG. 1 is a schematic structural diagram of a heat dissipation apparatus for a small-sized device according to an embodiment of the present invention;
FIG. 2 is another schematic structural diagram of a heat dissipation apparatus for a small-sized device according to an embodiment of the present invention;
FIG. 3 is another schematic structural diagram of a heat dissipation apparatus for a small-sized device according to an embodiment of the present invention;
FIG. 4 is another schematic structural diagram of a heat dissipation apparatus for a small-sized device according to an embodiment of the present invention; and
FIG. 5 is a schematic structural diagram of a circuit board heat dissipation system according to an embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person skilled in the art based on the embodiments of the present invention without creative efforts shall fall within the protection scope of the present invention.

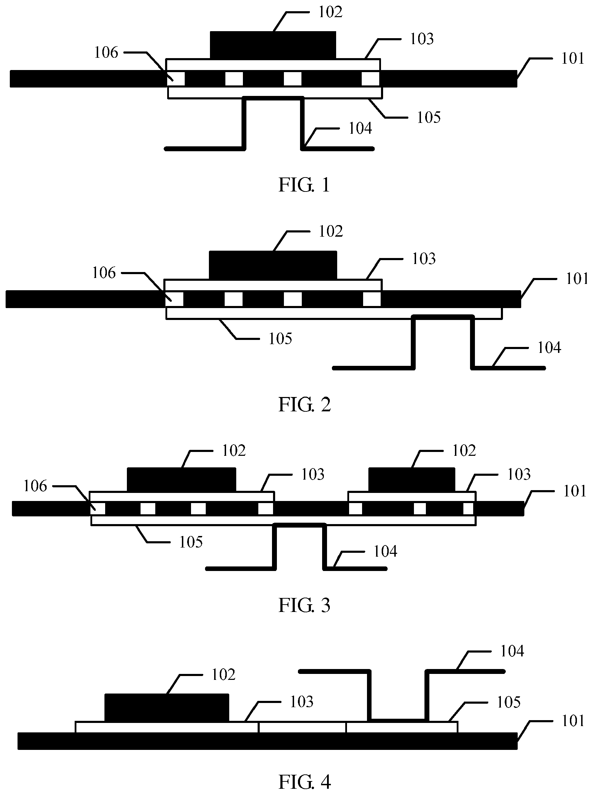

Referring to FIG. 1, an embodiment of a heat dissipation apparatus for a small-sized device in the embodiments of the present invention includes the following:
the heat dissipation apparatus is configured to dissipate heat of a small-sized device 102 on a circuit board 101;
the small-sized device 102 is welded to a copper sheet on the circuit board 101, and the copper sheet to which the small-sized device 102 is welded is referred to as a welded copper sheet 103 of the small-sized device;
the heat dissipation apparatus includes a heat sink 104; and
the heat sink 104 is welded to a copper sheet on the circuit board 101 and surrounds the small-sized device 102, and the copper sheet to which the heat sink 104 is welded is referred to as a welded copper sheet 105 of the heat sink.

It may be understood that the heat sink 104 may be welded to the copper sheet on the circuit board 101, and no other fastening manner is required. Therefore, the heat sink 104 has a simple structure and a relatively small size and is light.

In this embodiment of the present invention, a heat sink 104 is welded near a small-sized device 102, so that the heat sink 104 can dissipate heat generated by the small-sized device 102 or heat conducted by a nearby component, and a temperature rise of the small-sized device 102 is greatly reduced, where the temperature rise means that a temperature of a component is higher than an ambient temperature. In addition, the heat sink 104 is welded to a circuit board 101, and therefore no other fastening structure is required. The heat sink 104 has a simple structure, thereby meeting a product miniaturization trend and reducing heat dissipation costs of the small-sized device 102.

It may be understood that the small-sized device may be various components that have a relatively small size and that cannot easily dissipate heat, such as a LED, a transistor, a small-sized power amplifier, and a power triode, and no limitation is imposed herein.

In the foregoing embodiment, the heat sink 104 is welded to the copper sheet on the circuit board 101. In an actual application, in another embodiment of the heat dissipation apparatus for a small-sized device in the embodiments of the present invention, the heat sink 104 can be directly welded to the copper sheet on the circuit board 101 by a chip mounter by using a surface mount SMT technology.

Specifically, unlike a common heat-sink device that is fastened on a circuit board by using a spring screw or a steel nail, the heat sink 104 is a lightweight heat sink. When welding another component (for example, the small-sized device 102) to the circuit board 101 in a surface mount manner, the chip mounter may synchronously weld the heat sink 104 to the circuit board in a surface mount manner.

It may be understood that there may be multiple choices of a shape, a material, and a size of the heat sink 104 according to an actual application requirement, provided that a surface mount welding requirement can be met, and no limitation is imposed herein.

Optionally, in another embodiment of the heat dissipation apparatus for a small-sized device in the embodiments of the present invention, a material of the heat sink 104 may be copper or matte tinplate.

In this embodiment, the material of the heat sink 104 may be directly welded to the copper sheet on the circuit board 101, and no other processing is required. It may be understood that the material may be another material that can be directly welded to the copper sheet, and no limitation is imposed herein.

Optionally, in another embodiment of the heat dissipation apparatus for a small-sized device in the embodiments of the present invention, a material of the heat sink 104 may be stainless steel, aluminum, or galvanized steel sheet, and a surface of the heat sink is nickel-plated.

In this embodiment, it is inconvenient to directly weld the material of the heat sink 104 to the copper sheet on the circuit board 101. Therefore, nickel plating may be performed on a surface of the heat sink 104 manufactured by using these materials. In this way, the heat sink 104 may be welded to the copper sheet on the circuit board 101.

In the foregoing embodiment, the heat sink 104 needs to be welded to the circuit board 101 in a surface mount manner. In an actual application, in another embodiment of the heat dissipation apparatus for a small-sized device in the embodiments of the present invention, the heat sink 104 may be shaped by stamping and bending a sheet material.

It may be understood that a finished product obtained by stamping and bending a sheet material is generally light and thin and has a simple structure. After a proper size is selected according to a size of the small-sized device 102, the finished product may be used as the heat sink 104.

It may be understood that, in some specific application scenarios, the heat sink 104 is not limited to a sheet, but may be a cube or the like according to an actual requirement, provided that the cube or the like may be welded to the circuit board in a surface mount manner, meets a requirement of the heat sink 104 in this embodiment, and can well dissipate heat of the small-sized device 102.

Optionally, in an actual application, to enable the heat sink 104 to achieve a better heat dissipation effect, in another embodiment of the heat dissipation apparatus for a small-sized device in the embodiments of the present invention, the heat sink 104 may be Ω-shaped or pyramid-shaped.

In the foregoing embodiment, the heat sink 104 surrounds the small-sized device 102. In an actual application, for a position of the heat sink 104 relative to the small-sized device 102, there may be multiple choices.

Optionally, in another embodiment of the heat dissipation apparatus for a small-sized device in the embodiments of the present invention, as shown in FIG. 1, the heat sink 104 and the small-sized device 102 may be respectively distributed on both sides of the circuit board 101, and a central point of the small-sized device 102 and a central point of the heat sink 104 are located on a same perpendicular line perpendicular to the circuit board 101.

In this embodiment, the central point of the small-sized device 102 and the central point of the heat sink 104 are located on the same perpendicular line perpendicular to the circuit board 101. That is, a position of the heat sink 104 is right opposite to a position of the small-sized device 102. On the circuit board 101, the heat sink 104 is located at a shortest distance to the small-sized device 102 and can absorb the heat of the small-sized device 102 more efficiently, thereby improving an effect of dissipating, by the heat sink 104, the heat of the small-sized device 102.

Optionally, for ease arrangement of components on the circuit board 101, in another embodiment of the heat dissipation apparatus for a small-sized device in the embodiments of the present invention, as shown in FIG. 2, the heat sink 104 and the small-sized device 102 may be respectively distributed on both sides of the circuit board 101, and a central point of the small-sized device 102 and a central point of the heat sink 104 are not located on a same perpendicular line perpendicular to the circuit board 101.

In this embodiment, the heat sink 104 may further be disposed in a position in which the central point of the heat sink 104 and the central point of the small-sized device 102 are not located on the same perpendicular line perpendicular to the circuit board 101. A specific position may be determined according to arrangement of the components on the circuit board. In this way, the heat dissipation of the small-sized device 102 can be ensured, and another component may be easily arranged. In addition, as shown in FIG. 3, one heat sink 104 may simultaneously dissipate heat of multiple nearby small-sized devices 102, thereby improving heat dissipation efficiency of the heat sink 104.

It may be understood that, as shown in FIG. 1, to improve the effect of dissipating, by the heat sink 104, the heat of the small-sized device 102, the welded copper sheet 103 of the heat sink may be connected to the welded copper sheet 105 of the small-sized device by using a through hole 106 on the circuit board. In this way, the heat of the small-sized device 102 can be more easily conducted to the heat sink 104 for heat dissipation.

Optionally, in another embodiment of the heat dissipation apparatus for a small-sized device in the embodiments of the present invention, as shown in FIG. 3, both the heat sink 104 and the small-sized device 102 may be distributed on a same side of the circuit board 101.

In this embodiment, the heat sink 104 and the small-sized device 102 may further be distributed on the same side of the circuit board 101 according to a specific arrangement status of components. In this way, heat dissipation of the small-sized device 102 is ensured, and another component may be easily arranged. Likewise, one heat sink 104 may simultaneously dissipate heat of multiple nearby small-sized devices 102, thereby improving heat dissipation efficiency of the heat sink 104.

The following describes a circuit board heat dissipation system in an embodiment of the present invention. Referring to FIG. 1, the circuit board heat dissipation system in this embodiment of the present invention includes:
a circuit board 101, a small-sized device 102 welded to the circuit board 101, and the heat dissipation apparatus described in the foregoing embodiments, where the heat dissipation apparatus includes a heat sink 104.

In this embodiment of the present invention, in the circuit board heat dissipation system, a heat sink 104 welded near a small-sized device 102 can dissipate heat generated by the small-sized device 102 or heat conducted by a nearby component, and a temperature rise of the small-sized device 102 is greatly reduced. In addition, the heat sink 104 is welded to a circuit board 101, and therefore no other fastening structure is required. The heat sink 104 has a simple structure, thereby meeting a product miniaturization trend and reducing heat dissipation costs of the small-sized device 102.

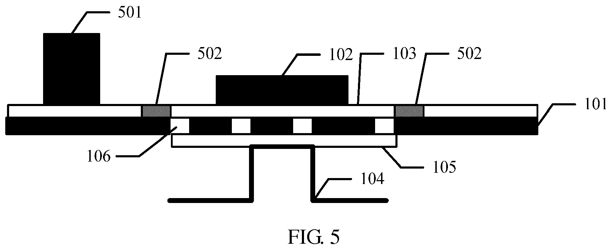

Optionally, in another embodiment of the circuit board heat dissipation system in the embodiments of the present invention, as shown in FIG. 5, in addition to the small-sized device 102, another component 501 may be welded to the circuit board. To reduce a heat impact of the another component 501 on the small-sized device 102, a welded copper sheet 105 of the small-sized device 102 may be isolated from a welded copper sheet of the another component 501 by using FR4 502.

In this embodiment, the welded copper sheet 105 of the small-sized device 102 is isolated from the welded copper sheet of the another component 501 on the circuit board by using the FR4 502. The FR4 has very high thermal-conduction resistance. Therefore, heat generated by the another component 501 cannot be easily conducted to the small-sized device 102; and when the heat dissipation apparatus dissipates heat of the small-sized device 102, heat conducted to the small-sized device 102 is greatly reduced, and a temperature rise of the small-sized device 102 is further reduced.

The foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of the embodiments of the present invention.

## Claims

1. A heat dissipation apparatus for a small-sized device, configured to dissipate heat of a small-sized device on a circuit board, wherein the heat dissipation apparatus comprises a heat sink;
the small-sized device is welded to a copper sheet on the circuit board; and
the heat sink is welded to a copper sheet on the circuit board and surrounds the small-sized device.

2. The heat dissipation apparatus according to claim 1, wherein that the heat sink is welded to the copper sheet on the circuit board specifically comprises the following:
the heat sink is directly welded to the copper sheet on the circuit board by a chip mounter by using a surface mount SMT technology.

3. The heat dissipation apparatus according to claim 1 or 2, wherein a material of the heat sink is copper or matte tinplate.

4. The heat dissipation apparatus according to claim 1 or 2, wherein a material of the heat sink is stainless steel, aluminum, or galvanized steel sheet, and a surface of the heat sink is nickel-plated.

5. The heat dissipation apparatus according to any one of claims 1 to 4, wherein the heat sink is shaped by stamping and bending a sheet material.

6. The heat dissipation apparatus according to claim 5, wherein the heat sink is Ω-shaped or pyramid-shaped.

7. The heat dissipation apparatus according to any one of claims 1 to 6, wherein the heat sink and the small-sized device are respectively distributed on both sides of the circuit board, and a center of the small-sized device and a central point of the heat sink are located on a same perpendicular line perpendicular to the circuit board.

8. The heat dissipation apparatus according to any one of claims 1 to 6, wherein the heat sink and the small-sized device are respectively distributed on both sides of the circuit board, and a central point of the small-sized device and a central point of the heat sink are not located on a same perpendicular line perpendicular to the circuit board.

9. The heat dissipation apparatus according to claim 7 or 8, wherein a welded copper sheet of the heat sink is connected to a welded copper sheet of the small-sized device by using a through hole in the circuit board.

10. The heat dissipation apparatus according to any one of claims 1 to 6, wherein both the heat sink and the small-sized device are distributed on a same side of the circuit board.

11. A circuit board heat dissipation system, comprising:
a circuit board, a small-sized device welded to the circuit board, and the heat dissipation apparatus according to any one of claims 1 to 11.

12. The heat dissipation system according to claim 11, wherein in addition to the small-sized device, another component is welded to the circuit board; and
a welded copper sheet of the small-sized device is isolated from a welded copper sheet of the another component by using FR4.
